# EUROPEAN PATENT SPECIFICATION

(11) **EP 3 184 666 B1**
(45) Date of publication and mention of the grant of the patent: **13.06.2018**
(21) Application number: 15202296.8
(22) Date of filing: 23.12.2015
(51) Int. Cl.: C23C 16/46, C23C 16/48

(54) **SYSTEM AND METHOD FOR GAS PHASE DEPOSITION**
SYSTEM UND VERFAHREN ZUR GASPHASENABSCHEIDUNG
SYSTÈME ET PROCÉDÉ DE DÉPÔT EN PHASE GAZEUSE

(43) Date of publication of application: 28.06.2017
(73) Proprietor: Singulus Technologies AG, 63796 Kahl am Main (DE)
(72) Inventor: IVANOV, Alexey, 52070 Aachen (DE); RICHTER, Johannes, 64807 Dieburg (DE)
(74) Representative: Vossius & Partner Patentanwälte Rechtsanwälte mbB

(56) References cited:
- WO-A1-2009/144456
- US-A- 4 836 138
- US-A- 5 551 985

## Description

The present invention relates to systems and methods for gas phase deposition of at least one material to a substrate having a first and a second surface opposite to the first surface using a heater to apply energy to the substrate from the side of the first surface and from the side of the second surface of the substrate.

In general, the deposition from the gas phase presumes the material transport towards the covering surface by utilizing the free space of pipes, channels and reactor volume. Thus, it differs from Liquid Phase Epitaxy (LPE) and Solid Phase Epitaxy or Crystallization. In most cases, additional energy is provided to the substrate surface, for example in the form of heat, light or plasma, to trigger the chemical reactions required to decompose the precursors containing specific components and/or enable synthesis of a desired compound directly on the substrates surface.

Therefore, the classic view on deposition processes and hardware made to implement the latter presumes, that only the substrate (i.e. it's growing surface) is energized (e.g. heated), but all other apparatus components remain cold (not energized), in order to avoid contamination of the open surfaces, i.e. surfaces other than the substrates surface, and therefore prevent the physical properties of the apparatus from drifting and to avoid the uncontrollable contamination by gases (O2, H2O etc) and particles (pieces of coatings layer delaminating from open surfaces) of the substrate and the growing layer because of desorption from the apparatus surfaces.

However, due to the heat-(energy) and mass-transfer in the reactor, during the deposition process, it is a challenge to keep the surrounding environment completely unaffected from the above mentioned phenomenon. This leads to uncontrollable desorption of gases and parasitic coatings in the reactor and causes unwanted influences from a previous process to the consecutive processes. The described influence is complex and is hard to be eliminated by the readjustment of process parameters, because the deposition itself is a complex matter, where several factors have to be considered and most of them depend on each other.

Several strategies have been elaborated during the past to overcome this issue and all of them have their own drawbacks.

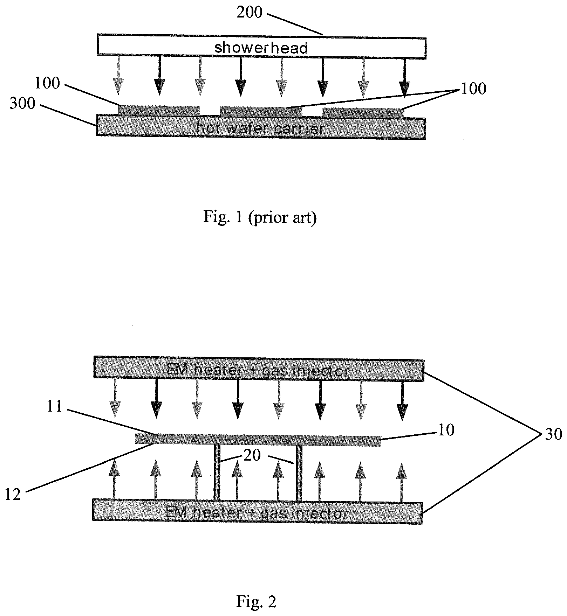

The classic approach is a so-called close coupled shower head (CCS) type of design, as illustrated in Fig. 1 developed by Thomas Swan & Co., GB, where a water cooled CCS 200 is located in direct proximity to the substrates surface 100 (5-25 mm) providing a high precursor utilization efficiency (e.g. up to 40%). Despite the water cooling CCS 200, the surface temperature might easily grow above 150°C, due to the heat of the hot substrate carrier 300, which is enough to decompose certain types of precursors (e.g. TMGa). The CCS 200 is getting the parasitic coating during the process, which has the above described negative effect on the following processes. The removal of such a coating usually cannot be performed without opening of the reactor and a subsequent mechanical treatment, which generates particles spread into the reactor or the surrounding area (e.g. glove box).

In order to improve the situation of the CCS design, it has been proposed to increase the distance between the hot substrate carrier 300 and the showerhead 200. Due to the increased distance between the showerhead 200 and the hot substrate carrier 300, the temperature of the showerhead 200 does not reach such high temperatures, so that the deposition of the precursor material on the showerhead 200 is reduced. However, this design leads to a substantial drop in precursor utilization efficiency (e.g. below 1%) and corresponding growth rate reduction to the level, where some processes become impossible or not feasible for production.

Furthermore, the systems described above utilize substrate heating from one side only, normally from the side opposite to the growing surface and, thus, creates thermal stress to the substrate. Consequently, the substrate might be bent, due to the temperature difference at the top and bottom side of substrate. The bent itself, which might be additionally caused by growing layers, has direct influence on the temperature uniformity on the substrate. Any "pocket profiling" on the substrate carrier can solve the issue only for the certain bow value. A pocket profile refers to the profile of the substrate holder, in which the substrate is placed during deposition. Pocket profiling is used to compensate temperature for non-uniformity caused by imperfect heating mechanism and by the substrate shape (substrate bending of e.g. up to 200µm). The pocket profile of the substrate holder may comprise a flat bottom surface on which the substrate is placed. Pocket profiling relates to providing different geometries, e.g. concave, step pocket profile or a combination thereof etc., optimized for certain substrate temperatures and certain substrate bends (bows). However, the pocket profile cannot be changed during the process to fit every parameter and a vertical temperature gradient (also leading to stress in the substrate) cannot be avoided.

Overall, the known systems suffer from a plurality of drawbacks, for example: (1) Parasitic residuals from a previous process, e.g. on static reactor surfaces, with impact on a consecutive run. (2) Mechanical stress in the substrate, due to the undesired temperature difference between the top and bottom surface. (3) The large temperature difference between the substrate 100 and the heater 300 leads to parasitic mass transfer from hotter areas (e.g. the heater) to colder areas (e.g. the substrate) and short heater lifetime. (4) Large heat capacity (high thermal mass) leads to low temperature ramping rate during the heat up and the cool down process. (5) Strong dependency of the heat transfer below 200 mbar causes the substrate temperature to drop down by e.g. >100 °C relative to the heater temperature. (6) Necessity of handling the carrier and its separation from the substrate make automatic cassette to cassette substrate transfer more troublesome and not economically desirable. (7) Remaining parasitic coating on single or multiple number of reactor parts such as carriers, susceptor, cover segments, ceilings etc. causes the necessity of their exchange and cleaning to avoid an impact on a consecutive run. (8) To open the reactor for maintenance, e.g. manual cleaning, reactor parts replacement, the heater has to be switched off, thus reducing the systems' throughput, i.e. increasing the cost of ownership (CoO) and increasing the chance of moisture and oxygen contamination, which has a further negative impact on a consecutive run. (9) The standard heating system leads to high (e.g. 10-20 kW) electrical power consumption per single substrate (e.g. D ≥ 150 mm) at temperatures higher than e.g. 1000°C. This has a negative impact on CO₂ emission and electricity consumption.

US 4 836 138 A discloses a heating system for use in chemical vapor deposition equipment of the type wherein a reactant gas is directed in a horizontal flow for depositing materials on a substrate which is supported in a reaction chamber on a susceptor which is rotatably driven for rotating the substrate about an axis which extends normally from its center.

US 5 551 985 A discloses a CVD reactor that includes a vacuum chamber having first and second thermal plates disposed therein and two independently-controlled multiple-zone heat sources disposed around the exterior thereof. The first heat source has three zones and the second heat source has two zones. A wafer to be processed is positioned below the first thermal plate and immediately above the second thermal plate, thereby being indirectly heated from above by the first heat source via the first thermal plate and indirectly heated from below by the first zone of the second heat source via the second thermal plate. A thermal ring plate which laterally surrounds the edge of the wafer absorbs heat energy emitted from the second zone of the second heat source and heats the outer edge of the wafer.

WO 2009/144456 A1 discloses a chemical vapor deposition (CVD) apparatus configured for thermal gradient enhanced CVD operation by the inclusion of multiple heaters, positioned so as to provide a desired thermal gradient profile across a vertical dimension of a substrate or other work piece within the chamber.

The object of the invention is to provide a gas phase deposition method and a system, which overcome the above mentioned problems of the prior art.

The object is achieved with the features of the independent claims. The dependent claims relate to further aspects of the invention.

The invention is based on the general inventive idea to provide for a well-defined heating of both surfaces of a substrate during deposition without contacting the substrate by the heater(s).

In one aspect of the present invention a system for gas phase deposition, e.g. vapor phase deposition (e.g. vapor phase epitaxy) of at least one material to a, e.g. planar, substrate having a first and a second surface opposite to the first surface is provided. The system comprises a holding member configured to hold the substrate, a deposition member configured to apply the at least one material to the substrate from at least one direction, and a heater located at a distance from the substrate and being configured to apply heat to the substrate from the side of the first surface and from the side of the second surface of the substrate.

Although the substrate may consist of any material with any geometrical form, used for the production of photonics (e.g. LED, lasers, photodiodes etc.), electronics (e.g. power electronics, high-frequency electronics, digitial electronics), photovoltaics etc. That is, the present invention may be used in connection with various substrates from different materials and geometries, e.g. according to substrates from materials and geometries according to the above fields.

The deposition member (gas injector) for the introduction of reactants diluted in a carrier gas for the growth, etching or simple purging functionality in case of pure carrier gas supply and the heater may be positioned in close proximity to each other. That is, the deposition member and the heater are located in accordance to each other to apply gas to the substrate from the side of the first surface and from the side of the second surface of the substrate. Thus, the application of gas to the first surface may be different than the gas applied to the second surface. That is, the application of heat and/or the application of gas to the first surface of the substrate may be different than the heat and/or gas to the second surface of the substrate. Preferably, the deposition member and the heater are incorporated into one system for applying heat and gas from the same directions to the first and second surface of the substrate.

The deposition member may comprise at least one first gas component hollow pin and at least one profiled or flat sheet reflector, wherein the at least one sheet reflector comprises at least one hole. A first gas component may be applied to the substrates' surface through the at least one hollow pin, whereas a second gas component is applied through the at least one hole of the at least one sheet reflector. The second gas component is preferably preheated while being purged to the substrate. Thus, the second gas component may reach the substrates' surface at a higher temperature; therefore, requiring less energy from the substrates' surface and time to get decomposed at higher efficiency (percentage of supplied material). As a consequence, the supplied amount of the second gas component may be reduced for the same deposition rate or may support higher deposition rate with unchanged supply, thus reducing the percentage of parasitic gas phase reaction rates above the substrate related to a chosen deposition rate, because the rate of parasitic gas phase reactions depends on the product of the concentrations of both components. Consequently, the deposition temperature may be reduced, while maintaining the same layer quality, because the second component requires less energy from the substrate to be decomposed. Also, the total gas flow through the reactor may be reduced in case the second gas component consists a valuable percentage of the total flow. Further advantageous effects of the deposition member will be apparent to the skilled person. The deposition member as described above may constitute an invention in conjunction with the present invention gas phase deposition system or method or in systems according to the prior art, i.e. without the presence of other features of the present invention, or even independently.

In addition, the deposition member may be configured to apply different processes to the first and second surfaces, that is, to apply a deposition process to the one side (e.g. first surface) and an etching process to the other side (e.g. second surface) at the same time or two different deposition processes at the same time.

The heater may be configured to apply heat of a first temperature to the first surface and a second temperature to the second surface of the substrate. That is, in certain cases the two temperatures may differ from each other to have a further degree of freedom of the heat distribution onto the two surfaces.

In particular, the heater may be configured to apply a first predetermined heat distribution to the first surface of the substrate and a second predetermined heat distribution to the second surface of the substrate. The first and second predetermined heat distributions may be the same or different from each other depending on the procedural requirements of the deposition and/or the properties of the substrate, like the material and/or the dimensions of the substrate.

Additionally due to the low heat capacity of the heater, the heat may be applied with relatively high variation in time up to (e.g. 800 °C/s) i.e. pulsed regime to achieve even lower average substrate temperature during the deposition process, while maintaining the high layer quality usual for higher substrate temperatures.

The heater may be configured as a three-dimensional heater, i.e. the heater may extend in three dimensions, possibly around the substrate. However, the heater may comprise different areas which can be separately controlled to apply heat only from predetermined areas of the three-dimensional heater.

The heater may comprise two or more 1-dimensional (linear) or 2-dimensional (circular - or equivalent to the shape of the substrate) heating units, wherein the first heating unit is located at a first distance to the first surface of the substrate and the second heating unit is located at a second distance to the second surface of the substrate. That is, the heating units allow for the application of heat to both surfaces of the substrate. The linear (ID) heater preferably comprises a series of linear heaters located above and below the substrate, and thus, enabling the construction of linear reactors, where the single substrate, a number thereof or even a rolled material can move back and forth (or only forth) while deposition of different materials or the same material under different conditions takes place at physically different locations. Furthermore, it may enable roll-to-roll or non-stop process flow for multiple substrates. It can further eliminate the heating-up and the cooling-down process, phase shifting them from the time space into physical space. Due to a local number of heating elements just above and below the substrate, the substrate can be "transferred" from one temperature range (suitable for a previous process step) to another one (suitable for a consecutive process step).

A circular (2D) heater presumes the standard classical approach, where the single substrate is statically located in the chamber during the whole deposition cycle including the temperature ramping process.

The heater (or the heating units) may be located asymmetrically with respect to the first and second surface of the substrate. That is, instead of applying heat at different temperatures to the two surfaces of the substrate, while the heater (or the heating units) is placed at an equal distance from the respective surfaces, the heater (or the heating units) may be placed at different distances from the two surfaces. The same effect can also be achieved by different temperature control of the heating units (or areas of the heater) as described above. That is, the temperature might be controlled in a way that the first temperature of the first heating unit is set to a first temperature and the second heating unit is set to a second temperature different from the first temperature.

In summary, the heat applied to the substrates surfaces may be different for each of the two surfaces. This may be achieved by either locating the heater (or the heating units) at different distances from the respective surfaces or by varying the temperature radiated by the heater (or the heating units) with respect to the two surfaces. In addition, the heater may be placed at different distances from the two surfaces and be set at different temperature values to be applied to the surfaces. Instead of placing the heater (or heating units) at different distances they may be located at certain angles with respect to the two surfaces. The angles might be the same for the respective heater or different to achieve a different heat distribution at the two surfaces.

The heater may be one of a resistive heater, a RF heater and an electromagnetic (EM) heater, and the heater is preferably configured to apply a profiled heat distribution to the substrate and/or configured to apply heat dynamically. That is, the heat applied to the substrate may be controlled in a way that the surface(s) of the substrate are subjected to a predetermined heat distribution (heat profile). For example, the heater may apply different temperatures to the edges of the substrates and to the center of the substrate, respectively, e.g. the temperature may gradually increase towards the center of the substrate. In addition, the temperatures may be applied dynamically, i.e. the applied heat may vary in a time dependent manner. That is, the amount of heat applied to the substrate and/or the heat distribution may be variably dependent on time. The growth process might be monitored and from this the heat distribution might be adjusted accordingly. Other process parameters might also be monitored and, thus, give rise to changed heat requirements, which may be adjusted accordingly.

There is no physical contact between the substrate and the heater according to the present invention. That is, without contact the heat can be transferred by thermal convection (e.g. by gas) or thermal radiation (e.g. EM or RF), i.e. radiated in vacuum. Thus, there is either light absorption or an electrical current caused by EM field variation. In the latter case, the substrate may be a conductor. In case of light, the substrate surface may be configured to absorb light. A resistive heater also radiates in the IR-visible spectrum, therefore, it may also be considered as an EM heater. Another option may be the use of a lamp (Mercury Cathode, LED etc.) or a laser (VCSEL). The heater itself does not comprise a heated surface, but rather emits EM energy towards the substrates' surface. In addition, femtosecond-(or picosecond) lasers emit light, which is absorbed by any solid surface even if it is transparent for a given wavelength. For example, sapphire is transparent in the visible spectra, but its surface (not the whole body) absorbs the femtosecond laser pulses, e.g. of nominally green light. Thus, only the surface of the substrate is heated without heating any other components of the deposition chamber and/or the bulk material.

The holding member may be positioned at at least one surface of the substrate. That is, the holding member may be positioned at the first and/or the second surface of the substrate or at a third and/or fourth surface of the substrate. The third and fourth surface may be the short sides in case of an elongated substrate, or the thin sides in thickness direction of a planar substrate. In other words, a substrate may comprise two main surfaces (top and bottom surface), where the deposition of the at least one material takes place. However, the holding member may be positioned on another surface than the two main surfaces, e.g. on a side surface (third and/or fourth surface). In case of a round substrate, the substrate may only have a third surface extending around the first and second surfaces. Whereas, in case of a rectangular substrate (e.g. a cuboid) the surface extending around the first and second surface may be subdivided in third to sixth surfaces, wherein two of the third to sixth surfaces are located opposite to each other. For example, the third and the fourth surface may correspond to surfaces (sides) of the rectangular substrate that are located opposite to each other.

The holding member may be positioned at a center region of one of the surfaces of the substrate or an edge region of one of the surfaces of the substrate. The holding member can be attached to the substrate at one or more positions. The holding member is designed to hold the sample at a certain distance to the heater. Depending on the geometry of the substrate the holding member is adapted to hold the substrate in a stable position, with minimal contact to the substrate to avoid shadowing effects, i.e. areas where no material can be deposited due to the contact of the holding member. By placing the holding member at the edge region of the substrate, it is possible to achieve uniform deposition of the center region of the substrate without any shadowing effects. In case the holding member is placed on the third and/or fourth surface or the thin sides of the substrate, a uniform deposition over the whole first and second surface may be achieved without any shadowing effects, while the substrate is held at a predetermined distance to the heater(s).

The holding member may also be a gas flow to achieve a levitation effect of the substrate, i.e. the substrate floats on the gas stream in order to keep the substrate at a predetermined distance to the heater(s).

According to another aspect of the present invention a method for gas phase deposition of at least one material to a substrate having a first and a second surface opposite to the first surface is provided. The method comprises the steps of holding the substrate using a holding member, applying heat to the substrate from the side of the first surface and from the side of the second surface of the substrate using a heater located at a distance from the substrate, and depositing the at least one material to the substrate from at least one direction.

Preferably, applying heat to the substrate comprises applying heat of a first temperature to the first surface and a second temperature to the second surface of the substrate.

In addition, applying heat to the substrate might further comprise applying heat to the substrate from a first distance to the first surface of the substrate and a second distance different from the first distance to the second surface of the substrate.

Applying heat to the substrate might even further comprise applying heat according to a predetermined profile to the substrate and/or dynamically applying heat to the substrate, i.e. the heat applied to the substrate is varied depending on time.

Furthermore, holding the substrate might comprise holding the substrate at the first surface and/or the second surface or at a third and/or fourth surface of the substrate.

The substrate may be held at a center region of one of the surfaces of the substrate or an edge region of one of the surfaces of the substrate.

According to the invention, the direction of the heat and the direction of applying the at least one material may be essentially identical.

Thus, the present invention as described herein has, amongst others, a plurality of advantages over the prior art. That is, in a system according to the present invention, parasitic coating residuals from a previous process can be easily thermally removed with, e.g., a Rapid Thermal Etching (RTE) process, due to the low heat capacity of the heater.

With a twin EM heater (TEMH) system, as described herein, the temperature difference between the top and bottom surface can be easily adjusted to get positive, negative or close to zero temperature difference between the two surfaces. Consequently, there will be no additional stress on the substrate during the heating up, cooling down or steady state process step.

In case of both heaters having a similar temperature, the temperature on the substrate may not be lower more than several °C (<10 °C), compared to hundred or more °C (>100 °C) in case of conventional systems. The heater life time will therefore be increased and parasitic mass transfer from the heater to the substrate can be suppressed. Also the composition and thickness uniformity will be improved due to the absence of the very hot surfaces or spots in direct proximity (contact) to the substrate.

With a TEMH of the present invention it is possible to achieve higher temperature ramping rates (e.g. >10 °C/s), compared to conventional systems (e.g. <2 °C/s). Also, due to the much lower heat capacity (mass), the passive cooldown process will take much less time (e.g. only 20%) and improve the throughput for production, wherein the capability for controlled cooldown processes remains.

In addition, as a double-side (EM) heater does not have any or just negligible influence of RP on the substrate temperature, high temperature and low pressure processes may be performed (e.g. AlN growth). That is, due to the contact based heat transfer of the conventional systems at low pressures and small gaps (e.g. ∼100um) between the substrate and the carrier, the thermal conductivity decreases significantly. With a larger gap (e.g. >2mm) as for the present invention, the contact based heat transfer is suppressed and the substrates' temperature is independent from the reactor pressure (RP), thus it's possible to achieve higher substrate temperature (ST) and keep its stability. Thus, RP and ST are independent from one another, and thus, single process parameter variation becomes possible.

According to the present invention there are no additional reactor parts, besides the substrate, to be replaced between the process runs.

Due to the effectiveness of TEMH, the power consumption per single substrate can be < 10kW, even if operating at high temperatures.

Some preferred embodiments are now described with reference to the drawings. For explanation purposes, various specific details are set forth, without departing from the scope of the present invention as claimed.
FIG. 1 illustrates a conventional gas phase deposition system.
FIG. 2 illustrates a gas phase deposition system according to a first embodiment of the present invention.
FIG. 3 illustrates an alternative holding system according to a second embodiment of the present invention.
FIG. 4 illustrates another alternative holding system according to a third embodiment of the present invention.

### Detailed description of preferred embodiments

Fig. 2 illustrates an exemplary embodiment of the present invention. Fig. 2 shows a twin electromagnetic heater (TEMH) 30 located at two sides (surfaces) 11, 12 of a planar substrate 10. The substrate is placed on top of a holding member 20. The holding member 20 according to the first embodiment is equally spaced at a center position of the substrate 10 and contacts the substrate 20 at the surface 12.

The holding member 20 comprises of at least two elongated pins in order to hold the substrate at an equal distance to the TEMH 30, wherein the distance may be changed from a lowest to a highest position defined by the process requirements. The geometry and the number of pins 20 may be adjusted according to the geometry of the substrate 10. That is, although three pins 20 may be sufficient to stably hold the substrate 10 in position more than three pins may be provided in order to achieve a more stable configuration. However, instead of pins 20, the holding member may comprise at least two elongated holding parts with a larger supporting area to place the substrate thereon. That is, the amount of the pins 20 depends on the specific geometry of the pins. A pin with a sufficiently large supporting area may also be sufficient to provide a stable configuration for the substrate. If the pins are provided as small needles (small supporting area), at least three pins should be provided to stably support the substrate.

Each EM heater part 30 may or may not have an incorporated gas injector (deposition member) for introduction of reactants for the growth and/or for the etching (e.g. purge gas only). The gas injector may only be incorporated into one of the heater units 30, or it may be completely independent (not shown) from the heater system 30, i.e. the gas nozzles may be separate from the heater unit 30. The distance between both EM heater parts 30 is larger than the substrate thickness plus its possible deformation. As each EM heater part 30 may have its own deposition member, it may be possible to apply different processes to the two surfaces 11, 12, that is, to apply a deposition process to the one side and an etching process to the other side or two different deposition processes at the same time.

As illustrated in Fig. 2, the heat (indicated by the arrows) is applied from both sides of the substrate 10 by the heater system 30. The heater system might be constructed of two separate heater units 30 as illustrated by Fig. 2. However, the heater system 30 may also be structured as a single part, as long as the heat is applied from the at least two opposite sides of the substrate 10.

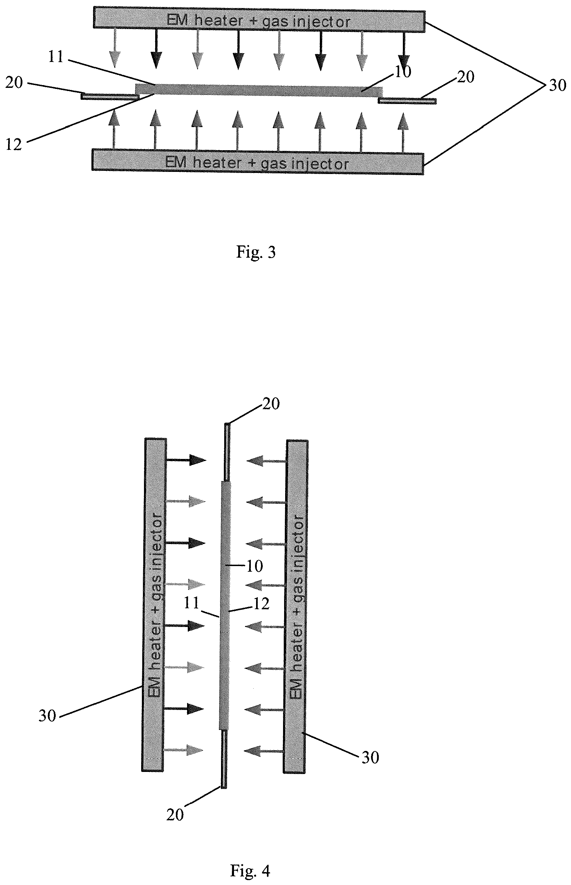

Fig. 3 shows an alternative embodiment, where the holding member 20 is attached at two edge positions of the substrate 10. That is, holding the substrate 10 near the edges, to avoid shadowing of the substrate center areas during the process. This embodiment is useful for stable substrates, which are not deforming under any process conditions, because of its own weight.

In an alternative embodiment (not shown), the holding member 20 may be attached to the edge of the substrate 10, by a clamping member attached to opposite surface sides of the substrate 10.

The holding member 20 may be placed at at least two or three circumferential edge positions of the substrate 10 or may extend around the whole substrate 10, i.e. extend completely around the substrate 10. The specific design may depend on the geometry of the substrates 10 and on the requirements on stability of the substrate.

Fig. 4 shows a further alternative embodiment of the present invention. Here, the holding member 20 is placed at two edges of the substrate 10 (other than surfaces 11, 12). The two other surfaces may be the short sides of an elongated substrate 10. In addition, the heater system 30 and the substrate 10 may be placed in a vertical direction, i.e. this embodiment is referred to as vertical disposition system. However, a horizontal setup as shown in Figs. 2 and 3 are also possible for the embodiment of Fig. 3.

In order to fix the holding member 20 to the substrates surfaces, the substrate 10 may comprise a groove at each of the two edge surfaces, and the holding member 20 may be attached to said groove. This can additionally provide movement and rotation functionality to introduce the substrate to or to remove it from the process chamber. In this case, there are no adverse shadowing effects at the two main surfaces 11, 12 of the substrate.

As the present invention may be embodied in several forms without departing from the scope or essential characteristics thereof, it should be understood that the above-described embodiments are not limited by any of the details of the foregoing descriptions, unless otherwise specified, but rather should be construed broadly within the scope as defined in the appended claims. The scope of the invention is defined according to the appended claims. Furthermore, in the claims the word "comprising" does not exclude other elements or steps, and the indefinite article "a" or "an" does not exclude a plurality. A single unit may fulfil the functions of several features recited in the claims. The terms "essentially", "about", "approximately" and the like in connection with an attribute or a value particularly also define exactly the attribute or exactly the value, respectively.

## Claims

1. System for gas phase deposition of at least one material to a substrate (10) having a first and a second surface (11, 12) opposite to the first surface (11), wherein the system comprises:
a holding member (20) configured to hold the substrate (10);
a deposition member configured to apply the at least one material to the substrate (10) from at least one direction; and
a heater (30) located at a distance from the substrate (10) and being configured to apply heat to the substrate (10) from the side of the first surface (11) and from the side of the second surface (12) of the substrate (10),
wherein the deposition member and the heater are located in accordance to each other for applying heat and gas from the same direction.

2. System according to claim 1, wherein the heater (30) is configured to apply heat of a first temperature to the first surface (11) and a second temperature to the second surface (12) of the substrate (10).

3. System according to claim 1 or 2, wherein the heater (30) is a three-dimensional heater.

4. System according to claim 1 or 2, wherein the heater (30) comprises at least two one- or two-dimensional heating units, wherein the first heating unit is located at a first distance to the first surface (11) of the substrate (10) and the second heating unit is located at a second distance to the second surface (12) of the substrate (10).

5. System according to any of claims 1 to 4, wherein the heater (30) is located asymmetrically with respect to the first and second surface (11, 12) of the substrate (10).

6. System according to any of claims 1 to 5, wherein the heater (30) is one of a resistive heater, a RF heater and an electromagnetic heater, and wherein the heater (30) is preferably configured to apply a profiled heat distribution to the substrate (10) and/or configured to apply heat dynamically.

7. System according to any of claims 1 to 6, wherein the holding member (20) is positioned at at least one surface of the substrate (10), wherein the holding member (20) is positioned at the first and/or the second surface (11, 12) of the substrate (10) or at a third and/or fourth surface of the substrate (10).

8. System according to any of claims 1 to 7, wherein the holding member (20) is positioned at a center region of one of the surfaces (11, 12) of the substrate (10) or an edge region of one of the surfaces (11, 12) of the substrate (10).

9. Method for gas phase deposition of at least one material to a substrate (10) having a first and a second surface (11, 12) opposite to the first surface (11), comprising the steps of:
(a) holding the substrate using a holding member (20);
(b) applying heat to the substrate (10) from the side of the first surface (11) and from the side of the second surface (12) of the substrate (10) using a heater (30) located at a distance from the substrate (10); and
(c) depositing the at least one material to the substrate (10) from at least one direction, wherein heat and gas are applied from the same direction.

10. Method according to claim 9, wherein step (b) comprises applying heat of a first temperature to the first surface (11) and a second temperature to the second surface (12) of the substrate (10).

11. Method according to claims 9 or 10, wherein step (b) further comprises applying heat to the substrate (10) from a first distance to the first surface (11) of the substrate (10) and a second distance different from the first distance to the second surface (12) of the substrate (10).

12. Method according to any of claims 9 to 11, wherein step (b) further comprises applying heat according to a predetermined profiled heat distribution to the substrate (10) and/or dynamically applying heat to the substrate (10).

13. Method according to any of claims 9 to 11, wherein in step (b) the amount of heat applied to the substrate (10) and/or the heat distribution is variably dependent on time.

14. Method according to any of claims 9 to 13, wherein step (a) further comprises holding the substrate (10) at the first surface (11) and/or the second surface (12) or at a third and/or fourth surface of the substrate (10), wherein step (a) preferably further comprises holding the substrate (10) at a center region of one of the surfaces (11, 12) of the substrate (10) or an edge region of one of the surfaces (11, 12) of the substrate (10).

15. Method according to any of claims 9 to 14, wherein in step (c) depositing from the at least one direction is equivalent to at least one of the directions from where the heat is applied to the first and/or second surfaces (11, 12) of the substrate (10).

16. Use of the system of any one of claims 1 to 8 or of the method of any one of claims 9 to 15 for vapor phase deposition, e.g. vapor phase epitaxy.

## Patentansprüche

1. System zur Gasphasenabscheidung von mindestens einem Material auf ein Substrat (10), das eine erste und eine zweite Oberfläche (11, 12) aufweist, die der ersten Oberfläche (11) gegenüberliegt, wobei das System aufweist:
ein Halteelement (20), das konfiguriert ist, das Substrat (10) zu halten;
ein Abscheidungselement, das konfiguriert ist, das mindestens eine Material auf das Substrat (10) aus mindestens einer Richtung aufzubringen; und
eine Heizvorrichtung (30), die in einem Abstand vom Substrat (10) angeordnet und konfiguriert ist, von der Seite der ersten Oberfläche (11) und von der Seite der zweiten Oberfläche (12) des Substrats (10) Wärme auf das Substrat (10) anzuwenden,
wobei das Abscheidungselement und die Heizvorrichtung zueinander entsprechend angeordnet sind, um Wärme und Gas aus derselben Richtung anzuwenden.

2. System nach Anspruch 1, wobei die Heizvorrichtung (30) konfiguriert ist, Wärme einer ersten Temperatur auf die erste Oberfläche (11) und einer zweiten Temperatur auf die zweite Oberfläche (12) des Substrats (10) anzuwenden.

3. System nach Anspruch 1 oder 2, wobei die Heizvorrichtung (30) eine dreidimensionale Heizvorrichtung ist.

4. System nach Anspruch 1 oder 2, wobei die Heizvorrichtung (30) mindestens zwei ein- oder zweidimensionale Heizeinheiten aufweist, wobei die erste Heizeinheit in einem ersten Abstand zur ersten Oberfläche (11) des Substrats (10) angeordnet ist und die zweite Heizeinheit in einem zweiten Abstand zur zweiten Oberfläche (12) des Substrats (10) angeordnet ist.

5. System nach einem der Ansprüche 1 bis 4, wobei die Heizvorrichtung (30) bezüglich der ersten und zweiten Oberfläche (11, 12) des Substrats (10) asymmetrisch angeordnet ist.

6. System nach einem der Ansprüche 1 bis 5, wobei die Heizvorrichtung (30) eine von einer Widerstandsheizvorrichtung, einer HF-Heizvorrichtung und einer elektromagnetischen Heizvorrichtung ist, und wobei die Heizvorrichtung (30) vorzugsweise konfiguriert ist, eine profilierte Wärmeverteilung auf das Substrat (10) anzuwenden, und/oder konfiguriert ist, Wärme dynamisch anzuwenden.

7. System nach einem der Ansprüche 1 bis 6, wobei das Halteelement (20) an mindestens einer Oberfläche des Substrats (10) angeordnet ist, wobei das Halteelement (20) an der ersten und/oder der zweiten Oberfläche (11, 12) des Substrats (10) oder an einer dritten und/oder vierten Oberfläche des Substrats (10) angeordnet ist.

8. System nach einem der Ansprüche 1 bis 7, wobei das Halteelement (20) an einem Mittelbereich einer der Oberflächen (11, 12) des Substrats (10) oder einem Randbereich von der Oberflächen (11, 12) des Substrats (10) angeordnet ist.

9. Verfahren zur Gasphasenabscheidung von mindestens einem Material auf ein Substrat (10), das eine erste und eine zweite Oberfläche (11, 12) aufweist, die der ersten Oberfläche (11) gegenüberliegt, das die Schritte aufweist:
(a) Halten des Substrats mittels eines Halteelements (20);
(b) Anwenden von Wärme auf das Substrat (10) von der Seite der ersten Oberfläche (11) und von der Seite der zweiten Oberfläche (12) des Substrats (10) mittels einer Heizvorrichtung (30), die in einem Abstand vom Substrat (10) angeordnet ist; und
(c) Abscheiden des mindestens einen Materials auf das Substrat (10) aus mindestens einer Richtung, wobei Wärme und Gas aus derselben Richtung angewendet werden.

10. Verfahren nach Anspruch 9, wobei Schritt (b) das Anwenden von Wärme einer ersten Temperatur auf die erste Oberfläche (11) und einer zweiten Temperatur auf die zweite Oberfläche (12) des Substrats (10) aufweist.

11. Verfahren nach Anspruch 9 oder 10, wobei Schritt (b) ferner das Anwenden von Wärme auf das Substrat (10) aus einem ersten Abstand auf die erste Oberfläche (11) des Substrats (10) und aus einem vom ersten Abstand verschiedenen zweiten Abstand auf die zweite Oberfläche (12) des Substrats (10) aufweist.

12. Verfahren nach einem der Ansprüche 9 bis 11, wobei Schritt (b) ferner ein Anwenden von Wärme gemäß einer vorgegebenen profilierten Wärmeverteilung auf das Substrat (10) und/oder ein dynamisches Anwenden von Wärme auf das Substrat (10) aufweist.

13. Verfahren nach einem der Ansprüche 9 bis 11, wobei im Schritt (b) die auf das Substrat (10) angewendete Wärmemenge und/oder die Wärmeverteilung variabel von der Zeit abhängt.

14. Verfahren nach einem der Ansprüche 9 bis 13, wobei Schritt (a) ferner das Halten des Substrats (10) an der ersten Oberfläche (11) und/oder der zweiten Oberfläche (12) oder an einer dritten und/oder vierten Oberfläche des Substrats (10) aufweist, wobei Schritt (a) vorzugsweise ferner das Halten des Substrats (10) an einem Mittelbereich von einer der Oberflächen (11, 12) des Substrats (10) oder einem Randbereich von einer der Oberflächen (11, 12) des Substrats (10) aufweist.

15. Verfahren nach einem der Ansprüche 9 bis 14, wobei im Schritt (c) das Abscheiden aus der mindestens einen Richtung zu mindestens einer der Richtungen äquivalent ist, aus der die Wärme auf die erste und/oder zweite Oberfläche (11, 12) des Substrats (10) angewendet wird.

16. Verwendung des Systems nach einem der Ansprüche 1 bis 8 oder des Verfahrens nach einem der Ansprüche 9 bis 15 zur Abscheidung aus der Dampfphase, z.B. zur Dampfphasenepitaxie.

## Revendications

1. Système pour le dépôt en phase gazeuse d'au moins un matériau sur un substrat (10) présentant une première et une deuxième surface (11, 12) opposée à la première surface (11), ledit système comprenant :
un élément de maintien (20) prévu pour maintenir le substrat (10) ;
un élément de dépôt prévu pour appliquer ledit au moins un matériau sur le substrat (10) dans au moins une direction ; et
un élément chauffant (30) situé à distance du substrat (10) et prévu pour une application de chaleur sur le substrat (10) du côté de la première surface (11) et du côté de la deuxième surface (12) du substrat (10),
où l'élément de dépôt et l'élément chauffant sont disposés de manière harmonisée entre eux pour une application de chaleur et de gaz dans la même direction.

2. Système selon la revendication 1, où l'élément chauffant (30) est prévu pour une application de chaleur à une première température sur la première surface (11) et à une deuxième température sur la deuxième surface (12) du substrat (10).

3. Système selon la revendication 1 ou la revendication 2, où l'élément chauffant (30) est un élément chauffant tridimensionnel.

4. Système selon la revendication 1 ou la revendication 2, où l'élément chauffant (30) comprend au moins deux unités de chauffage uni- ou bidimensionnelles, la première unité de chauffage étant située à une première distance de la première surface (11) du substrat (10) et la deuxième unité de chauffage étant située à une deuxième distance de la deuxième surface (12) du substrat (10).

5. Système selon l'une des revendications 1 à 4, où l'élément chauffant (30) est situé asymétriquement par rapport à la première et à la deuxième surface (11, 12) du substrat (10).

6. Système selon l'une des revendications 1 à 5, où l'élément chauffant (30) est soit un élément chauffant à résistance, soit un élément chauffant RF, soit un élément chauffant électromagnétique, et où l'élément chauffant (30) est préférentiellement prévu pour l'application d'une répartition de chaleur profilée sur le substrat (10) et/ou prévu pour une application dynamique de chaleur.

7. Système selon l'une des revendications 1 à 6, où l'élément de maintien (20) est disposé sur au moins une surface du substrat (10), l'élément de maintien (20) étant disposé sur la première et/ou la deuxième surface (11, 12) du substrat (10), ou sur une troisième et/ou une quatrième surface du substrat (10).

8. Système selon l'une des revendications 1 à 7, où l'élément de maintien (20) est disposé dans une partie centrale d'une des surfaces (11, 12) du substrat (10) ou dans une partie de bord d'une des surfaces (11, 12) du substrat (10).

9. Procédé de dépôt en phase gazeuse d'au moins un matériau sur un substrat (10) présentant une première et une deuxième surface (11, 12) opposée à la première surface (11), comprenant les étapes suivantes :
(a) maintien du substrat au moyen d'un élément de maintien (20) ;
(b) application de chaleur sur le substrat (10) du côté de la première surface (11) et du côté de la deuxième surface (12) du substrat (10) au moyen d'un élément chauffant (30) situé à distance du substrat (10) ; et
(c) dépôt dudit au moins un matériau sur le substrat (10) dans au moins une direction, la chaleur et le gaz étant appliqués dans la même direction.

10. Procédé selon la revendication 9, où l'étape (b) comprend une application de chaleur à une première température sur la première surface (11) et à une deuxième température sur la deuxième surface (12) du substrat (10).

11. Procédé selon la revendication 9 ou la revendication 10, où l'étape (b) comprend en outre une application de chaleur sur le substrat (10) à une première distance de la première surface (11) du substrat (10) et à une deuxième distance de la deuxième surface (12) du substrat (10), différente de la première distance.

12. Procédé selon l'une des revendications 9 à 11, où l'étape (b) comprend en outre une application de chaleur suivant une répartition définie de chaleur profilée sur le substrat (10) et/ou une application dynamique de chaleur sur le substrat (10).

13. Procédé selon l'une des revendications 9 à 11, où, lors de l'étape (b), la quantité de chaleur appliquée sur le substrat (10) et/ou la répartition de chaleur sont variables en fonction du temps.

14. Procédé selon l'une des revendications 9 à 13, où l'étape (a) comprend en outre le maintien du substrat (10) sur la première surface (11) et/ou la deuxième surface (12) ou sur une troisième et/ou une quatrième surface du substrat (10), l'étape (a) comprenant en outre préférentiellement le maintien du substrat (10) dans une partie centrale d'une des surfaces (11, 12) du substrat (10) ou une partie de bord d'une des surfaces (11, 12) du substrat (10).

15. Procédé selon l'une des revendications 9 à 14, où, lors de l'étape (c), la direction de dépôt dans ladite au moins une direction est équivalente à au moins une des directions dans laquelle la chaleur est appliquée sur la première et/ou la deuxième surface (11, 12) du substrat (10).

16. Utilisation du système selon l'une des revendications 1 à 8 ou du procédé selon l'une des revendications 9 à 15 pour un dépôt en phase vapeur tel qu'une épitaxie en phase vapeur.
